# EUROPÄISCHE PATENTSCHRIFT

(11) **EP 1 366 548 B1**
(45) Veröffentlichungstag und Bekanntmachung des Hinweises auf die Patenterteilung: **27.04.2005**
(21) Anmeldenummer: 02719854.8
(22) Anmeldetag: 15.02.2002
(51) Int. Cl.: H01S 5/183

(54) **OBERFLÄCHENEMITTIERENDER HALBLEITERLASER**
SURFACE-EMITTING SEMICONDUCTOR LASER
LASER SEMI-CONDUCTEUR A EMISSION PAR LA SURFACE

(30) Priorität: 15.02.2001 DE 10107349
(43) Veröffentlichungstag der Anmeldung: 03.12.2003
(73) Patentinhaber: Vertilas GMBH, 85748 Garching (DE)
(72) Erfinder: AMANN, Markus-Christian, 80935 München (DE); ORTSIEFER, Markus, 94227 Zwiesel (DE)
(74) Vertreter: Grunert, Marcus, Dipl.-Phys.
(86) Internationale Anmeldenummer: PCT/EP2002/001656
(87) Internationale Veröffentlichungsnummer: WO 2002/065599

(56) Entgegenhaltungen:
- EP-A- 0 184 117
- ORTSIEFER M ET AL: "Submilliamp long-wavelength InP-based vertical-cavity surface-emitting laser with stable linear polarisation" ELECTRONICS LETTERS, IEE STEVENAGE, GB, Bd. 36, Nr. 13, 22. Juni 2000 (2000-06-22), Seiten 1124-1126, XP006015366 ISSN: 0013-5194
- ORTSIEFER M ET AL: "LOW-THRESHOLD INDEX-GUIDED 1.5 MUM LONG-WAVELENGHT VERTICAL-CAVITY SURFACE-EMITTING LASER WITH HIGH EFFICIENCY" APPLIED PHYSICS LETTERS, AMERICAN INSTITUTE OF PHYSICS. NEW YORK, US, Bd. 76, Nr. 16, 17. April 2000 (2000-04-17), Seiten 2179-2181, XP000950426 ISSN: 0003-6951
- ORTSIEFER M ET AL: " CONTINUOUS-WAVE OPERATION OF 1.83-MUM VERTICAL-CAVITY SURFACE-EMITTING LASERS" IEEE PHOTONICS TECHNOLOGY LETTERS, IEEE INC. NEW YORK, US, Bd. 12, Nr. 11, November 2000 (2000-11), Seiten 1435-1437, XP000981055 ISSN: 1041-1135
- SCHRAUD G ET AL: "Substrateless singlemode vertical cavity surface-emitting GaAs/GaAlAs laser diode" ELECTRONICS LETTERS, IEE STEVENAGE, GB, Bd. 30, Nr. 3, 3. Februar 1994 (1994-02-03), Seiten 238-239, XP006000167 ISSN: 0013-5194

## Beschreibung

Die Erfindung betrifft einen Halbleiterlaser vom oberflächenemittierenden Typ mit einer einen pn-Übergang aufweisenden aktiven Zone sowie ein Verfahren zur Herstellung einer Diffusionsbarriere in einem solchen Halbleiterlaser.

Halbleiterlaser stellen im Prinzip eine in Flussrichtung betriebene Halbleiterdiode dar, die durch stimulierte Emission kohärentes, spektral schmalbandiges Licht erzeugt und gerichtet abstrahlt. Die für den Laserprozess notwendige Besetzungsinversion wird durch eine Strominjektion in den pn-Übergang erreicht. Als unterstützende Maßnahme kann eine hohe Dotierung des Ausgangsmaterials vorgesehen sein. Im Bereich des pn-Übergangs, in dem die Elektronen und Löcher räumlich benachbart vorliegen, erfolgt dann die induzierte strahlende Rekombination.

Der optische Resonator wird im einfachsten Fall aus zwei gegenüberliegenden, zum pn-Übergang senkrecht stehenden optischen Spiegeln gebildet. In dieser Bauform findet eine Emission in der Ebene senkrecht zur Strominjektion statt.

Alternativ dazu sind auch bereits oberflächenemittierende Halbleiterlaserdioden bekannt geworden, bei denen eine Emission senkrecht zur Ebene der aktiven Zone erfolgt. (engl: vertical-cavity surface-emitting laser diode, VCSEL).

Aus US 5 936 266 ist ein Halbleiterlaser vom oberflächenemittierenden Typ bekannt, bei dem ein ganzflächiger Tunnelkontakt dazu verwendet wird, um einen leitenden Übergang zwischen der p-Seite der aktiven Zone und einer n-dotierten Halbleiterschicht zu schaffen. Hierdurch wird die Verwendung von n-dotierten Halbleiterschichten auch auf der p-Seite der aktiven Zone möglich, wodurch sich aufgrund der besseren elektrischen Leitfähigkeit n-dotierter Halbleiter 10-30fach niedrigere elektrische Serienwiderstände ergeben. Ein Nachteil des ganzflächigen Tunnelkontakts besteht allerdings darin, dass zusätzliche Oxidschichten zur gezielten Stromführung vorgesehen sein müssen, die insgesamt zu einem aufwendigen und thermisch ungünstigen Aufbau des Halbleiterlasers führen.

Aus US 6 052 398 ist ein Halbleiterlaser vom oberflächenemittierenden Typ bekannt, der einen strukturierten Tunnelkontakt aufweist, wobei der Resonator durch zwei Halbleiterspiegel gebildet wird. Hierbei besteht das Problem, dass die Wärme über einen der Spiegel abgeführt werden muss, die üblicherweise aus ternären oder quaternären Mischkristallen mit dementsprechend schlechter thermischer Leitfähigkeit bestehen. Alternativ nennt die US 6 052 398 auch die Verwendung eines dielektrischen Spiegels auf der p-Seite der aktiven Zone, ohne dass für diese Alternativlösung besondere Vorteile genannt werden. In der Praxis wird diese Lösung zudem nicht eingesetzt, da reflektierende Kontaktschichten (in der Regel Gold oder Silber) in die angrenzenden Halbleiterschichten eindiffundieren können, so dass eine Langzeitstabilität nicht gewährleistet ist.

Die Veröffentlichung "Low-Threshold Index-Guided 1.5 µm Long-Wavelength Vertical-Cavity Surface-Emitting Laser With High Efficiency", Ortsiefer M. et al, Applied Physics Letters, American Insitute of Physics, New York, US, Volume 76, No. 16, 17 April 2000, Seiten 2179 bis 2181, beschreibt einen gattungsgemäßen Halbleiterlaser. Es hat sich jedoch gezeigt, dass Komponenten aus der Kontaktschicht in die zweite n-dotierte Halbleiterschicht diffundieren können, wodurch sich die Eigenschaften des Halbleiterlasers negativ verändern und im schlimmsten Fall strahlende Rekombinationen in der aktiven Zone vermindert werden können.

Die EP-A 0 184 117 behandelt eine LED-Diode und ein Verfahren zu ihrer Herstellung. Die Diode weist einen kleinflächigen Kontakt auf, wobei im unterhalb des Kontaktes liegenden Halbleitermaterial derjenige Anteil (beispielsweise durch Protonenimplantation) hochohmig gemacht ist, der im Bereich außerhalb der Umgrenzung des Kontaktes liegt. Zum Aufbau der Diode wird hier auf ein Halbleitersubstrat eine Halbleiter-Schichtstruktur aufgebracht, wobei zur Verhinderung von Diffusionen aus dem meist aus Gold bestehenden Kontakt in diese Halbleiterschichten eine Sperrschicht aufgebracht wird, die sich lateral über den gesamten Bereich der Diode ausdehnt. Zur Verhinderung der Diffusion von Gold aus dem Kontakt müsste die Schichtdicke der Sperrschicht jedoch derart groß sein, dass diese für die Wellenlängen der hier infrage kommenden Halbleiterlaser undurchlässig wäre, während sie eine ausreichende Durchlässigkeit für die erwähnte Protonenimplantation noch gewährt.

Aufgabe der Erfindung ist es, einen Halbleiterlaser bereitzustellen, der unter normalen Umgebungstemperaturen zu betreiben ist und ein stabiles Langzeitverhalten aufweist.

Diese Aufgabe wird durch einen Halbleiterlaser mit den Merkmalen des Patentanspruchs 1 gelöst. Im einzelnen umfassen die erfindungsgemäßen Merkmale einen Halbleiterlaser vom oberflächenemittierenden Typ, mit einer einen pn-Übergang aufweisenden aktiven Zone, mit einer ersten n-dotierten Halbleiterschicht.auf der n-Seite der aktiven Zone, mit einem strukturierten Tunnelkontakt auf der p-Seite der aktiven Zone, der einen leitenden Übergang zu einer zweiten n-dotierten Halbleiterschicht auf der p-Seite der aktiven Zone bildet, mit einem strukturierten dielektrischen Spiegel, der auf die zweite n-dotierte Halbleiterschicht aufgebracht ist, mit einer Kontaktschicht, die einen Kontakt zur zweiten n-dotierten Halbleiterschicht dort bildet, wo der dielektrische Spiegel nicht aufgebracht ist, und mit einer Diffusionsbarriere zwischen der Kontaktschicht und der zweiten n-dotierten Halbleiterschicht, wobei der dielektrische Spiegel die Diffusionsbarriere zum Teil überlappt.

Die erfindungsgemäße Lösung beruht auf der Erkenntnis, dass auf der p-Seite der aktiven Zone die dort befindliche n-dotierte Halbleiterschicht sowohl mit einem dielektrischen Spiegel, als auch mit einer Diffusionsbarriere gegenüber einer Kontaktschicht abgeschlossen wird. Die Kontaktschicht bildet eine Wärmesenke und ermöglicht damit eine effektive Wärmeableitung. Zur Bildung einer guten Wärmesenke bieten sich insbesondere Gold oder Silber an. Es wurde allerdings festgestellt, dass Komponenten aus diesen Schichten in die zweite n-dotierte Halbleiterschicht diffundieren und diese zerstören können. Die Diffusionsbarriere verhindert daher gemeinsam mit dem dielektrischen Spiegel, dass Komponenten aus der Kontaktschicht in die zweite n-dotierte Halbleiterschicht diffundieren und dabei im schlimmsten Fall in die aktive Zone geraten und dort die strahlende Rekombination unterdrücken. Damit besteht für die Materialwahl der Wärmesenke freie Hand, so dass insgesamt ein thermisch optimierter Aufbau eines Halbleiterlasers realisiert werden kann.

Ein erfindungsgemäßes Verfahren zum Aufbringen einer Diffusionsbarriere besteht aus den Merkmalen des Patentanspruchs 9, bei dem in einem ersten Bereich auf die zweite n-dotierte Halbleiterschicht die Diffusionsbarriere aufgebracht wird, bei dem in einem zweiten Bereich auf die zweite n-dotierte Halbleiterschicht ein dielektrischer Spiegel derart aufgebracht wird, dass der dielektrische Spiegel die Diffusionsbarriere zum Teil überlappt und bei dem die Kontaktschicht zumindest über die Diffionsbarriere aufgebracht wird.

Zusammenfassend weist der erfindungsgemäße Halbleiterlaser die folgenden Vorteile auf:
- Durch den strukturierten Tunnelkontakt auf der p-Seite der aktiven Zone können die restlichen Halbleiterschichten auf der p-Seite der aktiven Zone n-dotiert sein. Dadurch ergeben sich aufgrund der wesentlich besseren elektrischen Leitfähigkeit n-dotierter Halbleiter ca. 10-30 fach niedrigere elektrische Serienwiderstände.
- Die erste n-dotierte Halbleiterschicht auf der n-Seite der aktiven Zone dient als Ladungsträgereinschlussschicht.
- Auf der p-Seite wird ein hochreflektierender dielektrischer Spiegel verwendet. Zur Reflektivitätssteigerung kann eine metallische Abschlußschicht vorgesehen sein.
- Die Wärmeabfuhr erfolgt über die p-Seite, d. h. im wesentlichen durch den Tunnelkontakt und den dielektrischen Spiegel, der einen niedrigen thermischen Widerstand aufweisen kann.
- Zwischen dem aktiven Bereich und dem dielektrischen Spiegel kann eine thermisch gut leitende Schicht (z. B eine binäre InP-Schicht) zur Aufweitung und Abfuhr der Wärme eingesetzt werden.
- Eine integrierte, z.B. galvanisch hergestellte, metallische Wärmesenke, die auf der p-Seite großflächig aufgebracht wird, kann für eine effiziente Wärmeabfuhr sorgen. Die Metallschicht kann gleichzeitig als mechanische Stabilisation dienen, die insbesondere dann vorteilhaft ist, wenn auf der n-Seite das Substrat komplett entfernt wird, um z.B. einen erhöhten Brechzahlsprung zwischen dem epitaktischen Spiegel und Luft zu erhalten.
- Die Lichtauskopplung erfolgt vorzugsweise über die n-Seite (bezogen auf die aktive Schicht), so daß sich der teilweise absorbierende Tunnelkontakt auf der der Lichtauskopplung entgegengesetzten Seite befindet, wodurch höhere Lichtleistungen erzielt werden können.

Eine weitere Lösung, besteht in der Ausgestaltung des dielektrischen Spiegels. Übliche dielektrische Spiegel bestehen aus ternären oder quaternären Mischkristallen mit dementsprechend schlechter thermischer Leitfähigkeit. Zur Verbesserung der Wärmeleitfähigkeit wird in US 6,052,398 die Verwendung eines metamorphen Spiegels aus epitaktischem GaAs / AlAs vorgeschlagen. Dieser binäre Stoff weist zwar eine bessere Wärmeleitfähigkeit auf, verfügt allerdings über eine schlechte Gitteranpassung zu den angrenzenden Schichten, so dass infolge von Kristallversetzungen nur eine geringe Langzeitstabilität erreicht werden kann.

Als Lösung wird daher vorgeschlagen, für den dielektrischen Spiegel eine abwechselnde Abfolge von binären Schichten derart vorzusehen, dass die binären Schichten im Mittel eine gute Gitteranpassung zu den angrenzenden Schichten aufweisen. Beispielsweise können die binären Schichten abwechselnd aus InAs und GaAs mit Schichtdicken von jeweils 3nm bestehen, so dass der mittlere Gitterabstand der binären Schichten mit der angrenzenden Halbleiterschicht übereinstimmt.

Diese Lösung kann in Alleinstellung oder in Kombination mit der oben beschriebenen Lösung gemäß den Ansprüchen 1 und 9 verwirklicht werden.

Weitere bevorzugte Ausführungsformen ergeben sich aus den Unteransprüchen. Selbstverständlich sind die darin genannten und die nachstehend noch zu erläuternden Merkmale nicht nur in der jeweils angegebenen Kombination, sondern auch in anderen Kombinationen oder in Alleinstellung verwendbar.

Nach einer bevorzugten Ausführungsform ist zwischen der Diffusionsbarriere und der zweiten Halbleiterschicht ein Haftvermittler vorgesehen. Vorzugsweise besteht der Haftvermittler dabei aus einer Titanschicht und die Diffusionsbarriere aus einer Platinschicht. Außerdem kann zur Reflektivitätssteigerung zwischen dem dielektrischen Spiegel und der Kontaktschicht eine metallische Abschlussschicht vorgesehen sein. Zur Vereinfachung der Produktionsschritte kann die metallische Abschlußschicht durchgängig auch zwischen der Diffusionsbarriere und der Kontaktschicht vorgesehen sein.

Als Materialien eignen sich für die metallische Abschlussschicht Gold und für die Kontaktschicht Gold oder Silber.

Der dielektrische Spiegel besteht beispielsweise aus mehreren dielektrischen λ/4-Schichtpaaren, vorzugsweise gebildet aus Materialien mit großem Brechungsindexunterschied wie z.B. MgF₂ und Si.

Besonders vorteilhaft ist es, wenn der dielektrische Spiegel einen gegenüber den Halbleitermaterialien niedrigeren Wärmewiderstand aufweist, da hierdurch eine gerichtete Wärmeleitung erzielt wird. Die zweite n-dotierte Halbleiterschicht kann hierzu beispielsweise aus einem InP-Halbleiter bestehen.

Nach einer weiteren bevorzugten Ausführungsform ist vorgesehen, dass die Kontaktschicht derart dick aufgetragen ist, dass sie als Wärmesenke wirkt. Vorzugsweise ist dabei die Kontaktschicht ganzflächig aufgetragen und überdeckt auch den dielektrischen Spiegel. Die Dicke der Kontaktschicht kann beispielsweise 10µm betragen.

Nach einer weiteren bevorzugten Ausführungsform ist vorgesehen, dass die Lichtauskopplung auf der n-Seite der aktiven Zone erfolgt. Vorzugsweise wird hierzu das Substrat auf der n-Seite der aktiven Zone entfernt.

Im folgenden wird die Erfindung anhand verschiedener Ausführungsbeispiele mit Bezug auf die beiliegenden Zeichnungen näher erläutert. Es zeigen:
- Fig. 1: ein erstes Ausführungsbeispiel der Erfindung,
- Fig. 2: ein zweites Ausführungsbeispiel der Erfindung,
- Fig. 3: ein drittes Ausführungsbeispiel der Erfindung,
- Fig. 4: ein viertes Ausführungsbeispiel der Erfindung,
- Fig. 5: ein fünftes Ausführungsbeispiel der Erfindung,
- Fig. 6: drei Prozessschritte für die Herstellung einer Diffusionsbarriere nach einer ersten Ausführungsform und
- Fig. 7: drei Prozessschritte für die Herstellung einer Diffusionsbarriere nach einem nicht zur Erfindung gehörenden Beispiel

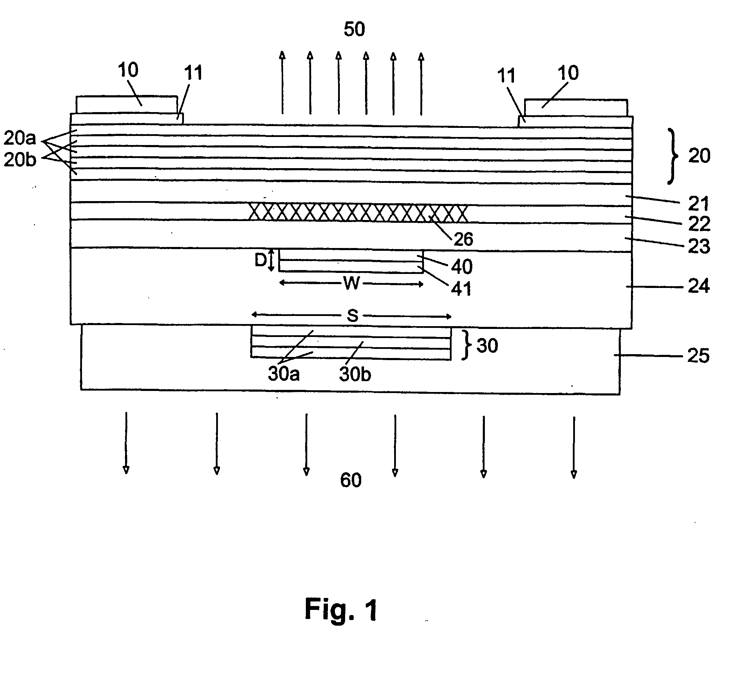

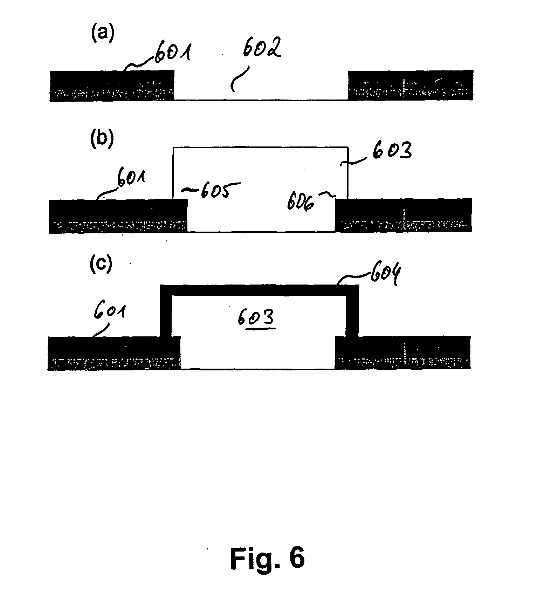

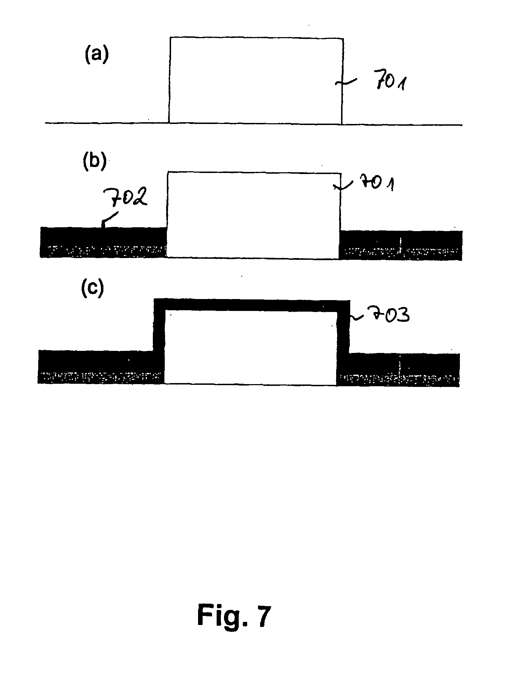

Anhand der Figuren 1 bis 5 werden zunächst fünf Ausführungsbeispiele der Erfindung beschrieben. Allen Ausführungsbeispielen gemeinsam ist eine Diffusionsbarriere zwischen der Kontaktschicht und der n-dotierten Halbleiterschicht auf der p-Seite der aktiven Zone. Die Prozessschritte zur Ausbildung der Diffusionsbarriere werden anhand der Figuren 6 und 7 erläutert.

Fig. 1 zeigt ein erstes Ausführungsbeispiel der Erfindung. Die Stromzuführung erfolgt über den unteren p-Kontakt (25), der gleichzeitig als integrierte Wärmesenke fungiert, und die n-Kontakte (10), die optional auf einer hochdotierten Kontaktschicht (11) aufgebracht sein können. Der Lichtaustritt erfolgt nach oben (50), während die Wärme über die integrierte Wärmesenke (25) nach unten (60) z. B. auf ein Kupfergehäuse abgeführt wird. Der laseraktive Bereich (26) befindet sich innerhalb der aktiven Schicht (22), die vorzugsweise aus einer verspannten Vielschichtstruktur besteht (engl.: Multiquantumwell: MQW-Struktur). Die seitlichen Abmessungen des laseraktiven Bereichs werden durch den Stromfluss durch den aus einer hoch p-dotierten Schicht (40) und einer hoch n-dotierten Schicht (41) bestehenden, seitlich z. B. kreisförmig (Durchmesser W) strukturierten Tunnelkontakt, sowie durch die seitliche Stromaufweitung in der Schicht (23) und die Ladungsträgerdiffusion in der aktiven Schicht (22) bestimmt. Die vertikale Begrenzung der in den aktiven Bereich injizierten Elektronen und Löcher wird durch die n-bzw. p-dotierten Begrenzungsschichten (21) und (23) geleistet.

Auf der n-Seite befindet sich der gemäß dem Stand der Technik epitaktisch hergestellte Spiegel (20), der beispielsweise aus vielen (z. B. 36) λ/4-Schichtpaaren zweier Halbleitermaterialien (20a) und (20b) mit unterschiedlichen Brechzahlen besteht. Der untere Spiegel (30) besteht aus einigen (z. B. 1.5 oder 2.5) Paaren von dielektrischen λ/4-Schichtpaaren (30a) und (30b), wie z. B. MgF₂ (30a) und Si (30b). Seine Reflektivität wird zusätzlich durch die Reflexion an der unteren Grenzfläche zur integrierten Wärmesenke (25) erhöht, insbesondere dann, wenn diese aus hochreflektierenden Metallen wie Gold oder Silber besteht.

In vertikaler Richtung wird der Tunnelkontakt in ein Minimum des elektromagnetischen Feldes gelegt, damit keine bzw. vernachlässigbare optische Verluste in den hochdotierten und absorbierenden Schichten (41) und (42) auftreten. Aus demselben Grunde sollte der Tunnelkontakt möglichst dünn sein; günstige Werte für die Gesamtdicke D betragen 20 bis 60nm für 1.3-1.55µm VCSEL. Die zweite p-seitige Halbleiterschicht (24) kann aufgrund des Tunnelkontakts (hoch) n-dotiert sein oder einen Gradienten in der n-Dotierung mit niedrigeren Dotierungen an der Grenze zur Schicht (23) und höheren Dotierungen an der Unterseite zum Spiegel (30) und der integrierten Wärmesenke (25) aufweisen. In jedem Fall besteht eine sperrende npn-Struktur neben dem Tunnelkontakt, die den Stromfluss dort blockiert, so dass der gesamte Strom durch den Tunnelkontakt in die aktive Schicht fließt. Die Schicht (24) sollte vorzugsweise eine gute thermische Leitfähigkeit besitzen, um den Wärmefluss aus dem aktiven Bereich zu verbessern und aufzuweiten (z. B auf ein Vielfaches des Durchmessers S) wodurch sich der Vorteil einer reduzierten Gesamterwärmung ergibt.

Aufgrund der Niederohmigkeit der n-dotierten Schicht (24) kann die seitliche Stromzuführung neben dem isolierenden dielektrischen Spiegel (30) ohne wesentliche elektrische Verluste bzw. ohne Wärmeerzeugung erfolgen. Die seitliche Abmessung S des dielektrischen Spiegels wird vorzugsweise mindestens so groß wie die seitliche Abmessung W des Tunnelkontakts gewählt. Besonders günstig ist es dabei, die Abmessung S um ca. 3-8µm größer als W (typ. 2-20µm bei 1.3µm und 1.55µm VCSELn) zu wählen, da die seitliche Ausdehnung des optischen Feldes aufgrund der Wellenführung durch die Verstärkung und die thermische Linsenwirkung (thermal lensing) des laseraktiven Bereichs (26) etwa auf die Abmessung des laseraktiven Bereichs begrenzt wird.

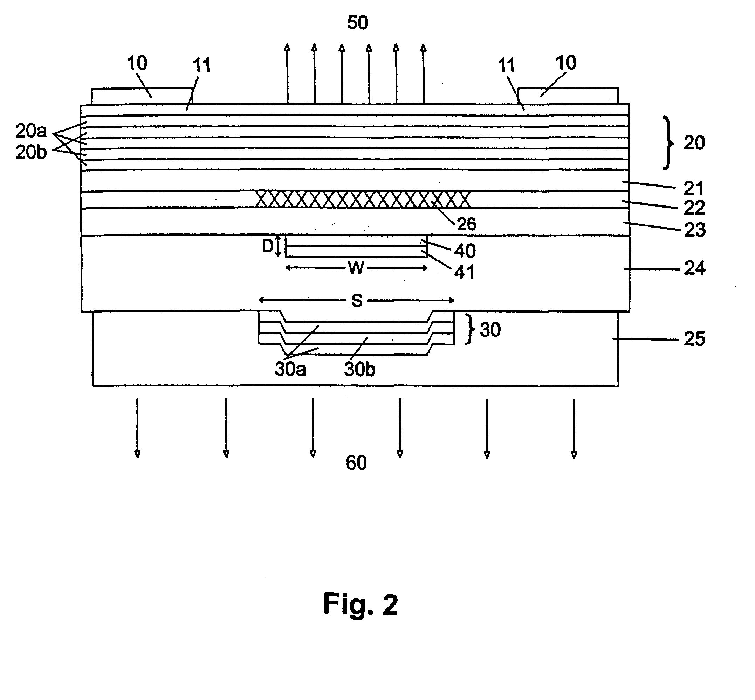

Fig. 2 zeigt ein zweites Ausführungsbeispiel der Erfindung. Hier wird im Unterschied zu Fig. 1 der Herstellungsprozess so gestaltet, dass sich die Struktur des Tunnelkontakts bei der epitaktischen Überwachsung in die Schichtoberfläche der Schicht (24) abbildet. Auf diese Weise entsteht eine verstärkte seitliche Wellenführung, die selbstjustierend exakt auf den Tunnelkontakt und den aktiven Bereich (26) ausgerichtet ist. Je nach Prozessführung kann dabei die Abbildung des Tunnelkontakts verbreitert oder verringert werden, womit sich die seitliche Begrenzung des optischen Feldes in weiten Grenzen beeinflussen lässt. Diese Methode lässt sich zur Optimierung der Lasereigenschaften grundsätzlich mit den nachfolgend beschriebenen Strukturvarianten kombinieren.

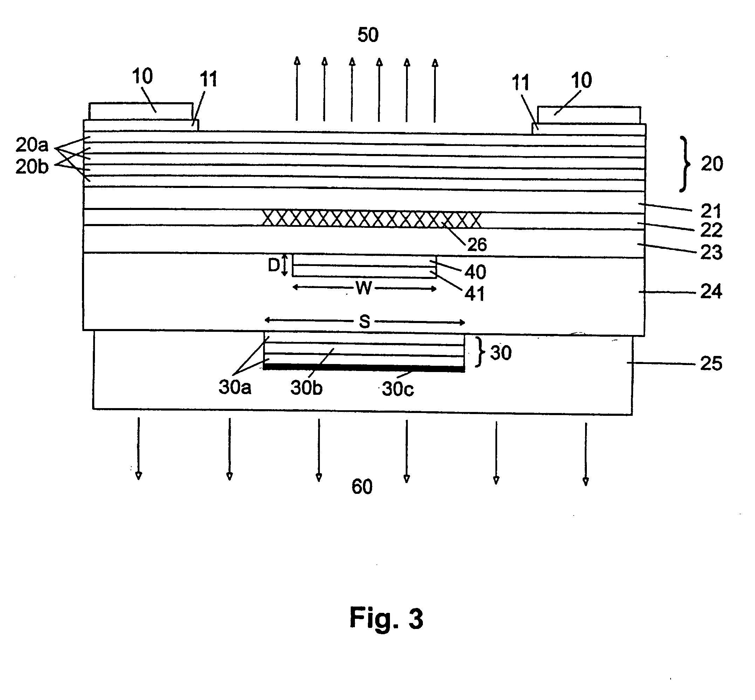

Fig. 3 zeigt ein drittes Ausführungsbeispiel der Erfindung. Hier wird deutlich hervorgehoben, wie durch das Aufbringen einer zusätzlichen hochreflektierenden metallischen Schicht (30c) auf den dielektrischen Spiegel (30) insgesamt eine hohe Reflektivität erzielt werden kann, die in dieser Ausführung nicht von den Eigenschaften der integrierten Wärmesenke und Kontaktschicht (25) abhängt.

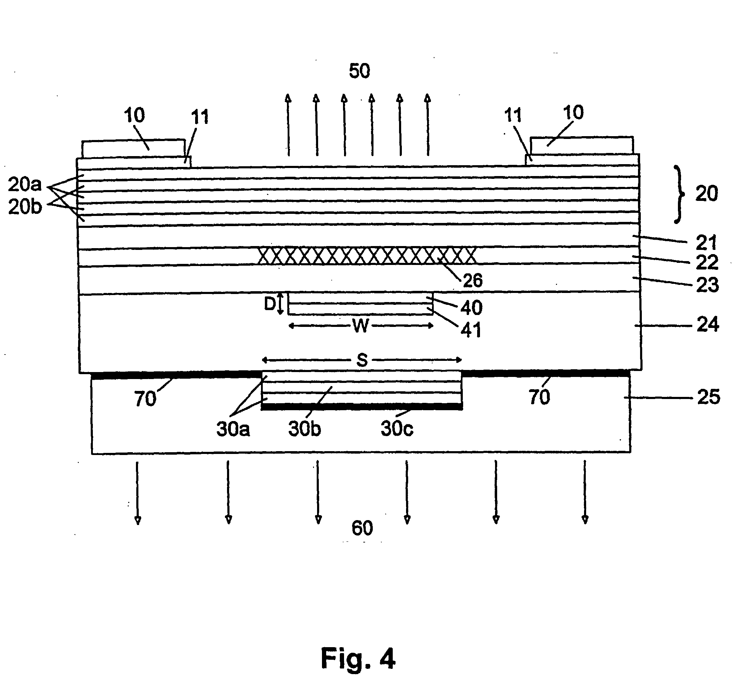

Fig. 4 zeit ein viertes Ausführungsbeispiel der Erfindung. Bei diesem Ausführungsbeispiel kann der p-seitige Kontaktwiderstand zur Kontaktschicht (25) durch seitliches Einfügen einer hoch n-dotierten Zwischenkontaktschicht (70) reduziert werden. Beispielsweise kann die Schicht (24) aus thermisch gut leitendem n-dotiertem InP und die Zwischenkontaktschicht (70) aus hoch n-dotiertem InGaAs bestehen, welches sehr niedrige Kontaktwiderstände ergibt.

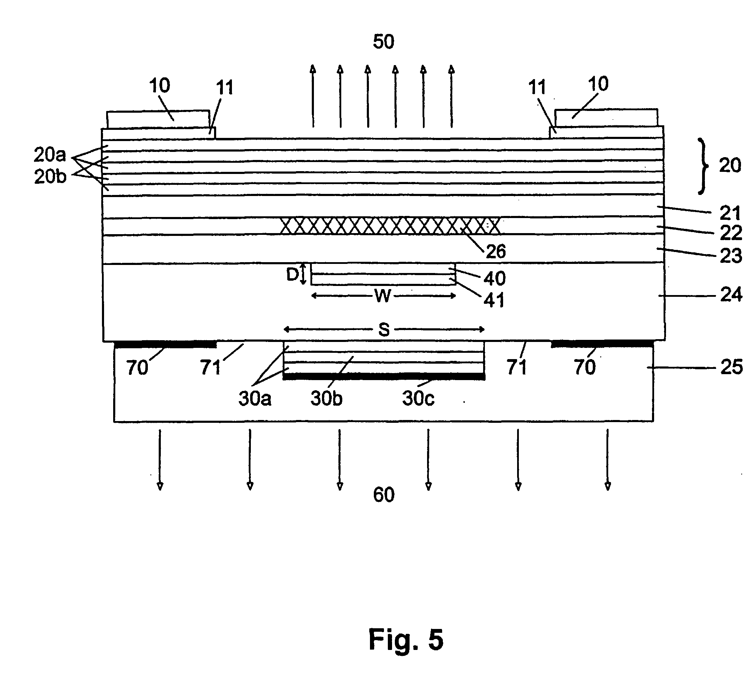

Da die n-dotierte Zwischenkontaktschicht gem. Fig. 4 thermisch schlecht leitend sein kann, wie im Beispiel des InGaAs, zeigt Fig. 5 ein fünftes Ausführungsbeispiel der Erfindung, bei dem sowohl ein niederohmiger Kontakt mittels der Zwischenkontaktschicht (70) als auch eine gute Wärmeabfuhr durch das Fenster (71) ermöglicht wird, indem zwischen dem dielektrischen Spiegel (30) und der Zwischenkontaktschicht (70) ein Zwischenraum geschaffen wird, über den die Warme abfließen kann. Die seitliche Breite des Bereichs (71) ist daher vorzugsweise größer als die Dicke der Schicht (24).

Fig. 6 zeigt drei Prozessschritte für die Herstellung einer Diffusionsbarriere nach einer Ausführungsform.

In einem ersten Schritt (a) wird in einem ersten Bereich eine Diffusionsbarriere 601 aufgebracht, während ein zweiter Bereich 602 maskiert wird. Die Diffusionsbarriere kann beispielsweise aus Platin (Pt) bestehen. Um eine bessere Haftung mit der darunter liegenden n-dotierten Halbleiterschicht zu erreichen, kann unter der Platinschicht eine Titanschicht aufgebracht werden. Schließlich kann auf die Platinschicht eine Goldschicht aufgebracht werden. In dieser Form besteht die Diffusionsbarriere dann aus der Schichtfolge Ti/Pt/Au.

In einem zweiten Schritt (b) wird in dem zweiten Bereich 602 ein dielektrischer Spiegel 603 aufgebracht. An den Stellen 605, 606 kann dabei eine gewisse Überlappung mit der Diffusionsbarriere 601 zugelassen werden. Diese Überlappung hat den Vorteil, dass ein dichter Abschluss zwischen dem dielektrischen Spiegel und der Diffusionsbarriere gewährleistet werden kann, so dass eine mögliche Diffusion aus der Kontaktschicht in die n-dotierte Halbleiterschicht sicher ausgeschlossen werden kann.

In einem dritten Schritt (c) folgt schließlich das Aufbringen einer Goldschicht 604 auf den dielektrischen Spiegel 603.

Fig. 7 zeigt drei Prozessschritte für die Herstellung einer Diffusionsbarriere nach einem nicht zur Erfindung gehörenden Beispiel. Der wesentliche Unterschied zu den Prozessschritten gem. Fig. 6 besteht darin, dass in einem ersten Prozessschritt (a) zunächst ein dielektrischer Spiegel aufgebracht wird, während in einem zweiten Prozessschritt (b) dann das Aufbringen der Diffusionsbarriere 702 erfolgt, die wiederum aus der bereits oben erwähnten Schichtfolge Ti/Pt/Au bestehen kann. In einem dritten Prozessschritt (c) folgt dann wieder das Aufbringen einer Goldschicht 703 auf den dielektrischen Spiegel. Bei der Prozessabfolge gem. Fig. 7 muss eine genaue Justage der Maskierung erfolgen, damit eine Diffusion zwischen dem dielektrischen Spiegel in die darunter liegende n-dotierten Halbleiterschicht nach wie vor verhindert wird.

In der Tabelle 1 sind schließlich typische Daten für eine erfindungsgemäße Halbleiterdiode aufgelistet, wobei sich die Nummern in der ersten Spalte auf die Bezugsziffern in den Figuren beziehen.

**Tabelle 1:**

| Typische Daten für eine erfindungsgemäße Halbleiterdiode mit 1.55µm Wellenlänge. Mit λ_{g} ist die dem Bandabstand entsprechende Wellenlänge gemeint. | | | | | | |
|---|---|---|---|---|---|---|
| **Nr.** | | **Material** | **Dotierung (cm**^{**-3**}**)** | **Dicke (nm)** | **Durchmesser (µm)** | **Bemerkung** |
| 10 | | Ti: 10nm | | ca. 530 | innen 55 | |
| | | Pt: 20nm | | | außen 240 | |
| | | Au: 500nm | | | | |
| 11 | | InGaAs | n=5x10¹⁹ | 100 | innen 50 | |
| | | (gitterangepaßt auf InP) | | | außen 250 | |
| 20 | 20 a | InGaAlAs (Brechzahl ca. 3.48) | n=2x 10¹⁸ | 111 | 250 | 36-mal wiederholt |
| | 20 b | InAlAs (Brechzahl ca. 3.2) | n=2x 10¹⁸ | 121 | 250 | |
| 21 | | InAlAs | n=5x 10¹⁷ | 50 | 250 | |
| 22 | | InGaAlAs (λ_{g}=1.1µm): 20nm | undotiert | 108 | 250 | |
| | | InGaAlAs(λ_{g}=1.7µm): 8nm | | | | |
| | | InGaAlAs(λ_{g}=1.1µm): 7nm | | | | |
| | | InGaAlAs(λ_{g}=1.7µm): 8nm | | | | |
| | | InGaAlAs(λ_{g}=1.1µm): 7nm | | | | |
| | | InGaAlAs(λ_{g}=1.7µm): 8nm | | | | |
| | | InGaAlAs(λ_{g}=1.1µm): 7nm | | | | |
| | | InGaAlAs(λ_{g}=1.7µm): 8nm | | | | |
| | | InGaAlAs(λ_{g}=1.1µm): 7nm | | | | |
| | | InGaAlAs(λ_{g}=1.7µm): 8nm | | | | |
| | | InGaAlAs (λ_{g}=1.1µm): 20nm | | | | |
| 23 | | InAlAs | p=5x10¹⁷ | 50 | 250 | |
| 24 | | InP | n=1-5x10¹⁸ | | | |
| 25 | | Ti: 10nm | | ca. | 250 | |
| | | Pt: 20nm | | 50µm | | |
| | | Au: 50µm | | | | |
| 30 | 30 a | MgF₂ | | 280 | 12 | 2x |
| | 30 b | Si | | 110 | 12 | 1x |
| 40 | | InGaAlAs (λ_{g}=1.4µm): | p=10²⁰ | 20 | 8 | |
| 41 | | InGaAs | n=10²⁰ | 20 | 8 | |
| | | (gitterangepaßt auf InP) | | | | |
| 50 | | Lichtaustrittsöffnung | | ca. 50µm | | |
| 60 | | Wärmeabfluß | | ca. 250µm | | |

## Patentansprüche

1. Halbleiterlaser vom oberflächenemittierenden Typ,
mit einer einen pn-Übergang aufweisenden aktiven Zone,
mit einer ersten n-dotierten Halbleiterschicht auf der n-Seite der aktiven Zone,
mit einem strukturierten Tunnelkontakt auf der p-Seite der aktiven Zone, der einen leitenden Übergang zu einer zweiten n-dotierten Halbleiterschicht auf der p-Seite der aktiven Zone bildet,
mit einem strukturierten dielektrischen Spiegel, der auf die zweite n-dotierte Halbleiterschicht aufgebracht ist,
mit einer Kontaktschicht, die einen Kontakt zur zweiten n-dotierten Halbleiterschicht dort bildet, wo der dielektrische Spiegel nicht aufgebracht ist, **gekennzeichnet durch** eine Diffusionsbarriere zwischen der Kontaktschicht und der zweiten n-dotieren Halbleiterschicht, wobei der dielektrische Spiegel die Diffusionsbarriere zum Teil überlappt.

2. Halbleiterlaser nach Anspruch 1, **dadurch gekennzeichnet, dass** zwischen der Diffusionsbarriere und der zweiten Halbleiterschicht ein Haftvermittler vorgesehen ist.

3. Halbleiterlaser nach Anspruch 2, **dadurch gekennzeichnet, dass** der Haftvermittler aus einer Titanschicht besteht.

4. Halbleiterlaser nach einem der Ansprüche 1 - 3, **dadurch gekennzeichnet, dass** die Diffusionsbarriere aus einer Platinschicht besteht.

5. Halbleiterlaser nach einem der Ansprüche 1 - 4, **dadurch gekennzeichnet, dass** zwischen dem dielektrischen Spiegel und der Kontaktschicht eine metallische Abschlussschicht zur Reflektivitätssteigerung vorgesehen ist.

6. Halbleiterlaser nach Anspruch 5, **dadurch gekennzeichnet, dass** die metallische Abschlußschicht durchgängig auch zwischen der Diffusionsbarriere und der Kontaktschicht vorgesehen ist.

7. Halbleiterlaser nach einem der Ansprüche 1 - 6, **dadurch gekennzeichnet, dass** die Kontaktschicht derart dick aufgetragen ist, dass sie als Wärmesenke wirkt.

8. Halbleiterlaser nach Anspruch 7, **dadurch gekennzeichnet, dass** Kontaktschicht über 10µm dick ist.

9. Verfahren zum Herstellen einer Diffusionsbarriere in einem Halbleiterlaser mit einer einen pn-Übergang aufweisenden aktiven Zone, mit einer ersten n-dotierten Halbleiterschicht auf der n-Seite der aktiven Zone,
mit einem strukturierten Tunnelkontakt auf der p-Seite der aktiven Zone, der einen leitenden Übergang zu einer zweiten n-dotierten Halbleiterschicht auf der p-Seite der aktiven Zone bildet,
bei dem in einem ersten Bereich auf die zweite n-dotierte Halbleiterschicht eine Diffusionsbarriere und in einem zweiten Bereich auf die zweite n-dotierte Halbleiterschicht ein dielektrischer Spiegel derart aufgebracht wird, dass der dielektrische Spiegel die Diffusionsbarriere zum Teil überlappt, und
bei dem eine Kontaktschicht zumindest über die Diffusionsbarriere aufgebracht wird.

10. Verfahren nach Anspruch 9, **dadurch gekennzeichnet, dass** der dielektrische Spiegel vor dem Aufbringen der Diffusionsbarriere aufgebracht wird.

11. Verfahren nach Anspruch 9, **dadurch gekennzeichnet, dass** der dielektrische Spiegel nach dem Aufbringen der Diffusionsbarriere aufgebracht wird.

12. Verfahren nach einem der Ansprüche 9 - 11, **dadurch gekennzeichnet, dass** vor der Diffusionsbarriere in ersten Bereich ein Haftvermittler aufgebracht wird.

13. Verfahren nach einem der Ansprüche 9 - 12, **dadurch gekennzeichnet, dass** als Haftvermittler Titan verwendet wird.

14. Verfahren nach einem der Ansprüche 9 - 13, **dadurch gekennzeichnet, dass** als Diffusionsbarriere Platin verwendet wird.

15. Verfahren nach einem der Ansprüche 9 - 14, **dadurch gekennzeichnet, dass** über der Diffusionsbarriere und dem dielektrischen Spiegel ganzflächig eine metallische Kontaktschicht aufgebracht wird.

16. Verfahren nach einem der Ansprüche 9 - 15, **dadurch gekennzeichnet, dass** vor dem Aufbringen der Kontaktschicht über dem dielektrischen Spiegel eine metallische Abschlüssschicht aufgebracht wird.

17. Verfahren nach einem der Ansprüche 9 - 15, **dadurch gekennzeichnet, dass** vor dem Aufbringen der Kontaktschicht ganzflächig über dem dielektrischen Spiegel und über die Diffusionsbarriere eine metallische Abschlussschicht aufgebracht wird.

## Claims

1. Semiconductor laser of the surface emitting type, comprising
an active zone having a pn transition,
a first n-doped semiconductor layer on the n side of the active zone,
a structured tunnel contact on the p side of the active zone which forms a conductive transition to a second n-doped semiconductor layer on the p side of the active zone,
a structured dielectric mirror which is applied to the second n-doped semiconductor layer,
a contact layer which forms a contact with the second n-doped semiconductor layer at the points where the dielectric mirror is not applied, **characterised**
**by** a diffusion barrier between the contact layer and the second n-doped semiconductor layer, the dielectric mirror partially overlapping the diffusion barrier.

2. Semiconductor laser according to claim 1, **characterised in that** an adhesion promoter is provided between the diffusion barrier and the second semiconductor layer.

3. Semiconductor laser according to claim 2, **characterised in that** the adhesion promoter consists of a layer of titanium.

4. Semiconductor laser according to one of claims 1 to 3, **characterised in that** the diffusion barrier consists of a layer of platinum.

5. Semiconductor laser according to one of claims 1 to 4, **characterised in that** a metallic covering layer for increasing reflectivity is provided between the dielectric mirror and the contact layer.

6. Semiconductor laser according to claim 5, **characterised in that** the metallic covering layer is provided right through between the diffusion barrier and the contact layer.

7. Semiconductor laser according to one of claims 1 to 6, **characterised in that** the contact layer is applied sufficiently thickly to act as a heat sink.

8. Semiconductor laser according to claim 7, **characterised in that** the contact layer is more than 10 µm thick.

9. Process for producing a diffusion barrier in a semiconductor laser with an active zone having a pn transition, with a first n-doped semiconductor layer on the n side of the active zone,
with a structured tunnel contact on the p side of the active zone which forms a conductive transition to a second n-doped semiconductor layer on the p side of the active zone,
wherein in a first region a diffusion barrier is applied to the second n-doped semiconductor layer and in a second region a dielectric mirror is applied to the second n-doped semiconductor layer in such a way that the dielectric mirror partially overlaps the diffusion barrier, and
wherein a contact layer is applied at least over the diffusion barrier.

10. Process according to claim 9, **characterised in that** the dielectric mirror is applied before the diffusion barrier is applied.

11. Process according to claim 9, **characterised in that** the dielectric mirror is applied after the diffusion barrier is applied.

12. Process according to one of claims 9 to 11, **characterised in that** an adhesion promoter is applied before the diffusion barrier in the first region.

13. Process according to one of claims 9 to 12, **characterised in that** titanium is used as the adhesion promoter.

14. Process according to one of claims 9 to 13, **characterised in that** platinum is used as the diffusion barrier.

15. Process according to one of claims 9 to 14, **characterised in that** a metallic contact layer is applied over the entire surface of the diffusion barrier and the dielectric mirror.

16. Process according to one of claims 9 to 15, **characterised in that** a metallic covering layer is applied before the contact layer is applied over the dielectric mirror.

17. Process according to one of claims 9 to 15, **characterised in that** a metallic covering layer is applied before the contact layer is applied over the entire surface of the dielectric mirror and the diffusion barrier.

## Revendications

1. Laser à semi-conducteur du type à émission de surface comprenant :
- une zone active présentant une transition pn ;
- une première couche semi-conductrice à dopage n sur la face n de la zone active ;
- un contact tunnel structuré sur la face p de la zone active qui forme une transition conductrice vers une seconde couche semi-conductrice à dopage n sur la face p de la zone active ;
- un miroir diélectrique structuré qui est appliqué sur la seconde couche semi-conductrice à dopage n ; et
- une couche de contact qui forme un contact avec la seconde couche semi-conductrice à dopage n, là où le miroir diélectrique n'est pas appliqué ;
**caractérisé par** une barrière de diffusion entre la couche de contact et la seconde couche semi-conductrice à dopage n, le miroir diélectrique recouvrant en partie la barrière de diffusion.

2. Laser à semi-conducteur selon la revendication 1, **caractérisé en ce qu'**un agent adhésif est prévu entre la barrière de diffusion et la seconde couche semi-conductrice.

3. Laser à semi-conducteur selon la revendication 2, **caractérisé en ce que** l'agent adhésif est constitué d'une couche de titane.

4. Laser à semi-conducteur selon l'une des revendications 1 à 3, **caractérisé en ce que** la barrière de diffusion est constituée d'une couche de platine.

5. Laser à semi-conducteur selon l'une des revendications 1 à 4, **caractérisé en ce qu'**une couche terminale métallique est prévue entre le miroir diélectrique et la couche de contact pour augmenter la réflectivité.

6. Laser à semi-conducteur selon la revendication 5, **caractérisé en ce que** la couche terminale métallique est prévue en continue aussi entre la barrière de diffusion et la couche de contact.

7. Laser à semi-conducteur selon l'une des revendications 1 à 6, **caractérisé en ce que** la couche de contact est appliquée avec une épaisseur telle qu'elle fait office de puits thermique.

8. Laser à semi-conducteur selon la revendication 7, **caractérisé en ce que** la couche de contact a une épaisseur supérieure à 10 µm.

9. Procédé pour fabriquer une barrière de diffusion dans un laser à semi-conducteur comprenant :
- une zone active présentant une transition pn, avec une première couche semi-conductrice à dopage n sur la face n de la zone active ; et
- un contact tunnel structuré sur la face p de la zone active qui forme une transition conductrice vers une seconde couche semi-conductrice à dopage n sur la face p de la zone active,
dans lequel une barrière de diffusion est appliquée dans une première région sur la seconde couche semi-conductrice à dopage n et dans lequel un miroir diélectrique est appliqué dans une seconde région sur la seconde couche semi-conductrice à dopage n, de sorte que le miroir diélectrique recouvre en partie la barrière de diffusion, et dans lequel une couche de contact est appliquée au moins sur la barrière de diffusion.

10. Procédé selon la revendication 9, **caractérisé en ce que** le miroir diélectrique est appliqué avant l'application de la barrière de diffusion.

11. Procédé selon la revendication 9, **caractérisé en ce que** le miroir diélectrique est appliqué après l'application de la barrière de diffusion.

12. Procédé selon l'une des revendications 9 à 11, **caractérisé en ce qu'**un agent adhésif est appliqué dans la première région avant la barrière de diffusion.

13. Procédé selon l'une des revendications 9 à 12, **caractérisé en ce que** du titane est utilisé comme agent adhésif.

14. Procédé selon l'une des revendications 9 à 13, **caractérisé en ce que** du platine est utilisé comme barrière de diffusion.

15. Procédé selon l'une des revendications 9 à 14, **caractérisé en ce qu'**une couche de contact métallique est appliquée sur toute la surface sur la barrière de diffusion et sur le miroir diélectrique.

16. Procédé selon l'une des revendications 9 à 15, **caractérisé en ce qu'**une couche terminale métallique est appliquée sur le miroir diélectrique avant l'application de la couche de contact.

17. Procédé selon l'une des revendications 9 à 15, **caractérisé en ce qu'**une couche terminale métallique est appliquée sur toute la surface sur le miroir diélectrique et sur la barrière de diffusion avant l'application de la couche de contact.
